# EUROPEAN PATENT SPECIFICATION

(11) **EP 4 312 249 B1**
(45) Date of publication and mention of the grant of the patent: **04.11.2026**
(21) Application number: 23156739.7
(22) Date of filing: 15.02.2023
(51) Int. Cl.: H10W 40/00, H10W 40/22, H10W 40/40, H10W 70/02

(54) **PIN FIN PLACEMENT ASSEMBLY FOR FORMING TEMPERATURE CONTROL ELEMENT UTILIZED IN DEVICE DIE PACKAGES**
STIFTRIPPENPOSITIONIERUNGSANORDNUNG ZUR FORMUNG EINES TEMPERATURREGELUNGSELEMENTS ZUR VERWENDUNG IN VORRICHTUNGSCHIPGEHÄUSEN
ENSEMBLE DE PLACEMENT D'AILETTE DE BROCHE POUR FORMER UN ÉLÉMENT DE RÉGULATION DE TEMPÉRATURE UTILISÉ DANS DES BOÎTIERS DE PUCE DE DISPOSITIF

(30) Priority: 29.07.2022 US 202217876813
(43) Date of publication of application: 31.01.2024
(73) Proprietor: Google LLC, Mountain View, CA 94043 (US)
(72) Inventor: TANG, Yingshi, Mountain View, 94043 (US); WANG, Yingying, Mountain View, 94043 (US); JAIN, Padam, San Jose, 95139 (US); SAMADIANI, Emad, Mountain View, 94043 (US); UDHAYAKUMAR, Sudharshan Sugavanesh, Mountain View, 94043 (US); IYENGAR, Madhusudan K., Mountain View, 94043 (US)
(74) Representative: Betten & Resch

(56) References cited:
- JP-A- 2012 129 336
- JP-A- 2016 009 718
- US-A- 5 292 054
- US-A1- 2009 314 467
- US-A1- 2012 241 953
- US-A1- 2015 179 551
- US-A1- 2021 098 335

## Description

### BACKGROUND

Electronic components such as chip assemblies or integrated circuit (IC) dies are often used in electronic devices, such as tablets, computers, copiers, digital cameras, smart phones, control systems, and automated teller machines, among others. The demand for high-performance electronic devices has led to developments in electronic component designs. For instance, to increase the performance of an electronic component, the size of the electronic component is often decreased, while the number of integrated components (e.g., transistors) within the electronic component is increased. However, the decrease in size and increase in the number of components in the electronic components can lead to thermal management issues, such as overheating. Such overheating may result in device failure or electrical performance deterioration.

Documents US 2012/0241953 A1, JP2016009718 A, JP2012129336 A and US5292054 A are examples of prior art electronic components.

### SUMMARY

A method for manufacturing an IC package is disclosed as recited in claim 1. A pin fin placement assembly is disclosed as recited in claim 12. Further embodiments are recited in the dependent claims.

The present disclosure relates to a pin fin placement assembly utilized to form a temperature control element that may be utilized in an IC package assembly. The temperature control element may include a plurality of pin fins disposed on solder paste. The pin fin placement assembly is utilized to dispose pin fins on an IC die disposed in the IC package. The pin fin placement assembly may assist with placing and soldering the pin fins on desired locations of the IC die. The pin fins of the temperature control element may be an integral part of the IC package assembly that may assist temperature control of the IC die when in operation. When such IC package assembly with temperature control element is assembled, the thermal dissipation efficiency for the overall IC package is then enhanced. In one example, a method for manufacturing a temperature control element in an IC package includes placing a pin fin placement assembly on a PCB including an IC die disposed thereon. A plurality of pin fins is provided in a first plurality of apertures in the pin fin placement assembly. A thermal process is performed. The plurality of pin fins is soldered on the IC die.

In one example, the pin fin placement assembly is removed from the PCB. The plurality of pin fins is provided in the first plurality of apertures formed in a top plate of the pin fin placement assembly.

In one example, the plurality of pin fins is driven in the first plurality of apertures in the top plate by vibration or brushing. A middle plate is pulled in the pin fin placement assembly in a lateral direction. The plurality of pin fins is dropped down from the first plurality of apertures in the top plate to a second plurality of apertures formed in a bottom plate disposed below the middle plate.

In one example, the first plurality of apertures formed in the top plate is vertically aligned with the second plurality of apertures formed in the bottom plate. The plurality of pin fins is maintained in a second plurality of apertures formed in a bottom plate in the pin fin placement assembly while performing the thermal process. The pin fins are soldered onto a corresponding solder bump formed on the IC die. The pin fin placement assembly is placed in an alignment hole formed in the PCB. The pin fin placement assembly allows the plurality of pin fins to be placed on the IC die simultaneously.

In one example, a manifold is placed on the PCB to encase the IC die therein while maintaining the plurality of pin fins located in a plenum defined in the manifold. A fluid is supplied into the plenum to regulate a thermal energy transmitted from the IC die. The pin fins are manufactured from a material selected from copper, aluminum, tungsten, gold, silver, combinations thereof or alloys thereof. The plurality of pin fins has a circular configuration, a rectangular configuration, or a longitudinal structure.

In one example, the plurality of pin fins is arranged in one or more arrays or matrices.

Another aspect of the technology is directed to a method for manufacturing a temperature control element in an IC package. The method includes placing a pin fin placement assembly on a PCB including an IC die disposed thereon. The pin fin placement assembly includes a top plate, a middle plate, and a bottom plate vertically assembled.

In one example, a plurality of pin fins is provided in a first plurality of apertures in the top plate of the pin fin placement assembly. The middle plate is laterally moved to allow the plurality of pin fins dropped in a second plurality of aperture in a bottom plate in the pin fin placement assembly. A thermal process is performed. The plurality of pin fins is soldered on the IC die.

In one example, the top plate of the pin fin placement assembly is removed prior to performing the thermal process. The plurality of pin fins is maintained in a second plurality of apertures in the bottom plate while performing the thermal process. A manifold is placed on the PCB to encase the IC die therein while maintaining the plurality of pin fins located in a plenum defined in the manifold. A fluid is supplied into the plenum to regulate a thermal energy transmitted from the IC die.

Yet another aspect of the technology is directed to a pin fin placement assembly. The pin fin placement assembly includes a top plate, a middle plate, and a bottom plate vertically assembled to form a plate body. The middle plate is laterally movable relative to the top plate or the bottom plate. A supporting post is disposed below the plate body. A first plurality of apertures is formed in the top plate. A second plurality of apertures formed in the bottom plate. The first and the second plurality of apertures are vertically aligned. The first and the second apertures are configured to receive pin fins to be disposed on an IC die

### DESCRIPTION OF THE DRAWINGS

FIG. 1 depicts a cross-sectional view of a temperature control element utilized in an IC package assembly in accordance with aspects of the disclosure.
FIGS. 2A-2J depict cross-sectional views of an IC package assembly at different stages of manufacturing a temperature control element on an IC die of the IC package assembly using a pin fin placement assembly in accordance with aspects of the disclosure.
FIGS. 3A-3B depict cross-sectional views of an example of a pin fin placement assembly.
FIGS. 4A-4B depict cross-sectional views of an example of a pin fin placement assembly.
FIG. 5 depicts a cross-sectional view of an example of temperature control elements formed by the pin fin placement assembly in accordance with aspects of the disclosure.
FIG. 6A depicts a cross-sectional view of a plurality of thermal dissipating features in accordance with aspects of the disclosure.
FIG. 6B depicts a top view of the plurality of thermal dissipating features of FIG. 4A in accordance with aspects of the disclosure.
FIG. 7A depicts a cross-sectional view of another example of a plurality of thermal dissipating features in accordance with aspects of the disclosure.
FIG. 7B depicts a top view of the plurality of thermal dissipating features of FIG. 7A in accordance with aspects of the disclosure.
FIG. 8 depicts a flow diagram for manufacturing an IC package including a temperature control element formed therein in accordance with aspects of the disclosure.

### DETAILED DESCRIPTION

The present disclosure relates to a pin fin placement assembly utilized to form pin fins in a thermal dissipating feature that may be utilized to dispose pin fins on an IC die disposed in the IC package. The pin fin placement assembly may assist massively placing the pin fins with desired profiles and numbers on desired locations of the IC die. The pin fins may be an integral part of the IC package assembly that may assist temperature control of the IC die when in operation. When such IC package assembly with the pin fins are assembled, the thermal dissipation efficiency for the overall IC package is then enhanced. In one example, a plurality of thermal dissipating features are disposed on a first surface of an IC die encased under a manifold to efficiently control and dissipate the thermal energy from the IC die when in operation. A second surface opposite to the first surface of the IC die may include a plurality of devices, such as semiconductors transistors, devices, electrical components, circuits, or the like, that may generate thermal energy when in operation. In one example, the thermal dissipating features may include a plurality of pin fins disposed on the IC die. The pin fins may be disposed on the IC die by utilizing a pin fin placement assembly during the manufacturing process. The pin fin placement assembly may assist with placing and holding the pin fins at desired locations on the IC die efficiently and precisely. Different configurations of the thermal dissipating features may be utilized to accommodate different device layouts with different thermal energy generation across the substrate in the IC die.

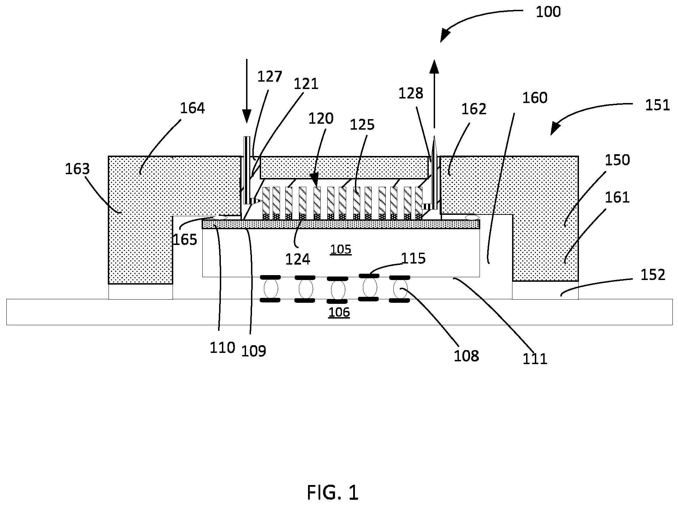

FIG. 1 depicts a cross sectional-view of an IC package 100, including an IC die 105 formed on a printed circuit board (PCB) 106. Although the example depicted in FIG. 1 only includes one IC die 105 and one PCB 106, it is noted that an IC package may include any number of IC dies, and PCBs. The IC dies and the devices or chip assemblies disposed within the IC package 100 may be in any numbers. In one example, the IC die 105 may be a graphics processing unit (GPU), custom application-specific integrated circuit (ASIC), memory devices, high-bandwidth memory (HBM) components, or any other type of device or stack. In one example, the IC die 105 is disposed on the PCB 106 through a plurality of solder balls 108 arranged in a ball grid array (BGA). Other arrangements and connectors may include contacts arranged in a land grid array (LGA), connector pins arranged in a pin grid array (PGA), etc.

In one example, a temperature control element 151 is utilized to encase the IC die 105. The temperature control element 151 overlies an adhesive material 152. The adhesive material 152 provides a sealing interface between the temperature control element 151 and the PCB 106. The temperature control element 151 includes a manifold 150 having a first side wall 161 and a second sidewall 163 connected by a ceiling 162, forming a substantially U-shape body 164 that defines a central cavity 160 on a bottom side of the manifold 150. The central cavity 160 encases IC die 105 when the temperature control element 151 is placed or mounted on the PCB 106. A sealing member 165 may be utilized to seal the interface where the manifold 150 is in contact with the IC die 105. In one example, the sealing member 165 may be an adhesive material, an O ring, or suitable mechanical attachments that facilitate positioning and securement of the manifold 150 to the IC die 105. A plenum 121 may be defined in the ceiling 162 of the manifold 150. The plenum 121 may allow fluid, air, liquid, or other such cooling material to be introduced therein for temperature control purposes to the IC die 105 when the temperature control element 151 is in place for operation.

A plurality of thermal dissipating features 120 may be disposed on a first surface 109 of the IC die 105 that may assist in dissipating thermal energy from the IC die 105 when IC die 105 is in operation. In one example, the plurality of thermal dissipating features 120 may be disposed on the first surface 109 of the IC die 105 by plating, soldering, or any other suitable process. A second surface 111 is formed substantially in parallel and opposite to the first surface 109 where a plurality of device structures 115 may be disposed. A metallization layer 110 may be formed on the surface 109 of the IC die 105 to facilitate soldering the plurality of thermal dissipating features 120 thereon. In one example, the metallization layer 110 may be manufactured from a conductive material, such as copper, aluminum, tungsten, nickel, silver, iron, combinations thereof, alloys thereof or the like.

In one example, each of the thermal dissipating features 120 may include a pin fin 125 disposed on solder paste 124 or solder pumps. The solder paste 124 may secure the metallic pin fins 125 onto the first surface 109 of the IC die 105 once soldered. In one example, the pin fin 125 may be manufactured from a metallic material that has good thermal dissipation or thermal transmission efficiency. Examples of metallic materials that may be selected to manufacture the pin fin 125 include copper, aluminum, tungsten, gold, silver, combinations thereof, alloys thereof, or the like. In one example, the pin fin 125 may have an aspect ratio, such as a height to diameter ratio, between about 1:1 and 20:1, such as about 10:1 or 5:1.

In one example, the thermal dissipating features 120 may be disposed on the surface 109 of the IC die 105 in the form of one or more arrays or matrices. In one example, The pin fin 125 may have a pitch between about 100 µm and about 500 µm, such as between about 150 µm and about 300 µm, such as about 200 µm. When in operation, fluid may be supplied from an inlet 127 to circulate through the plenum 121 to an outlet 128. In one example, the number and configuration of inlets and outlets can vary, such as an inlet disposed between two outlets, two inlets and two outlets, etc. The fluid as supplied may include liquid, air, or other suitable cooling mediums that may efficiently reduce the temperature of the IC die 105 with which the fluid is in direct contact. The thermal dissipating features 120, such as the pin fins 125 included therein, may increase contact surface area when the fluid is in circulation in the plenum 121. The increased contact surface provided area may enhance the cooling performance.

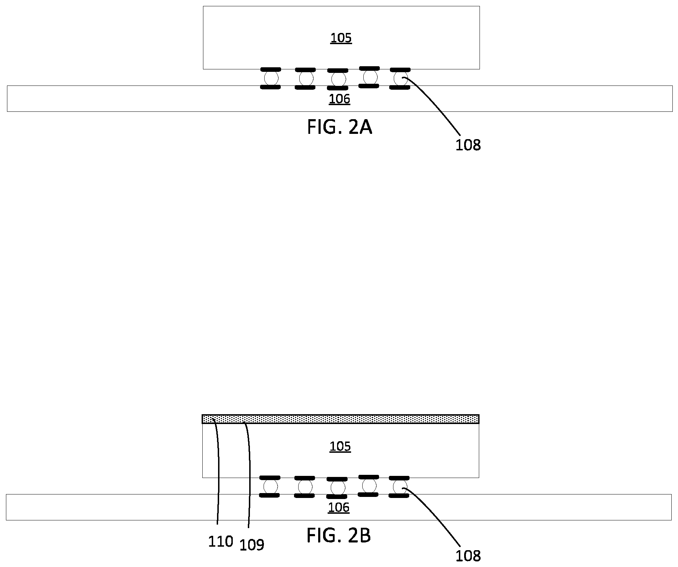

FIGS. 2A-2J depict cross-sectional views of an IC package assembly during different stages of implementing the temperature control element on the IC die 105 of FIG. 1. In FIG. 2A, the IC die 105 is soldered on the PCB 106. After the IC die 105 is soldered, the metallization layer 110 may be disposed or otherwise formed on the surface 109 of the IC die 105, as shown in FIG. 2B. In some examples, the metallization layer 110 may be disposed or otherwise formed on the surface 109 of the IC die 105 prior to soldering the IC die 105 to the PCB 106. For example, the metallization layer 110 may be deposited or formed on the IC die 105 as part of the manufacturing steps fulfilled by the IC manufacturing facilities prior to shipping to the IC packaging facility to be soldered on the PCB 106.

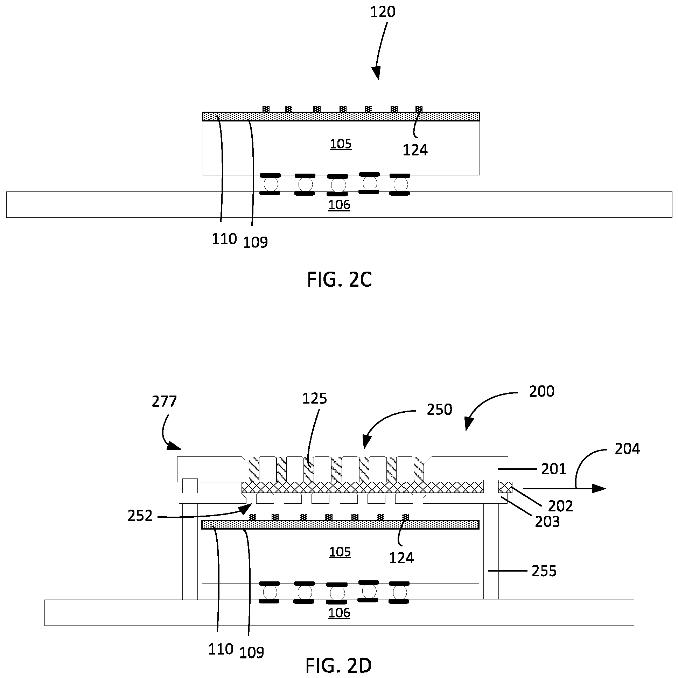

In FIG. 2C, a plurality of the solder paste 124 is printed and disposed on the surface 109 of the IC die 105. The solder paste 124 may facilitate attaching the pin fins 125 onto the surface 109 of the IC die 105 for temperature control when in operation.

In FIG. 2D, a pin fin placement assembly 200 is utilized to place the pin fins 125 onto the solder paste 124. In one example, as depicted in FIG. 2D, the pin fin placement assembly 200 includes a top plate 201, a middle plate 202, and a bottom plate 203 vertically assembled to form a plate body 277. The plate body 277 is disposed on one or more supporting posts 255. The supporting posts 255 may serve as alignment pins that may be placed into alignment holes (not visible in FIG. 2D) formed in the PCB 106. In one example, the top plate 201 has a plurality of apertures 250 formed therein and configured to receive pin fins 125 therein. The pin fins 125 may be pre-manufactured metallic structures with desired profiles and configurations. For example, the pin fins 125 may be pre-manufactured metallic structures with desired aspect ratios, such as a particular diameter to height ratio. The profile may be adjusted such that the pin fins, when soldered onto the IC die 105, adequately dispatch heat generated by the IC die to the cooling material.

The dimensions, distributions, and the numbers of the apertures 250 formed in the top plate 201 may be configured to accommodate the dimensions of the pin fins 125. In one example, the dimensions, distributions, and the numbers of the pin fins 125 may be determined based on the amount of thermal energy needed to be dispatched from the IC die 105 where the pin fins 125 are mounted. For example, when a higher thermal flux of thermal energy is desired to be dispatched from the IC die 105, higher numbers or higher placement density of the pin fins 125 may be configured to be formed on the IC die 105. It is noted that the dimensions, distributions, profiles, and the numbers of the pin fins 125 may be configured in any manner.

In one example, the pin fins 125 may be poured and placed into the apertures 250 of the top plate 201. Ultrasonic vibrations, mechanical movements or mechanical vibrations, or a brush may be utilized to drive the pin fins 125 into the apertures 250 of the top plate 201, as shown in FIG. 2D. Once the pin fins 125 are placed and filled in the apertures 250 of the top plate 201 above the middle plate 202, redundant pin fins 125 may be removed from the top plate 201.

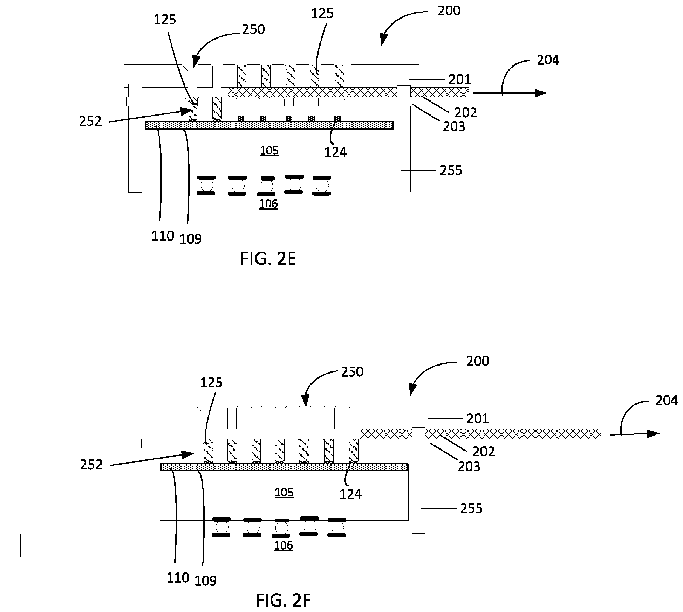

In FIG. 2E, the middle plate 202 is partially pulled out in a lateral direction, as shown by arrow 204. Once the middle plate 202 is pulled, the pin fins 250 in the top plate 201 without the support from the middle plate 202 are dropped down to the apertures 252 formed in the lower plate 203. The apertures 252 in the lower plate 203 are vertically aligned with the apertures 250 formed in the top plate 201 to allow the pin fins 125 to be dropped down to a desired position on the IC die 105 through the alignment from the lower plate 203. In one example, the pin fins 125 are configured to be dropped down to the corresponding solder paste 124 to dispose on the IC die 105. Thus, when the middle plate 202 is laterally pulled, the pin fins 125 may then be dropped down onto the corresponding solder paste 124.

In FIG. 2F, the middle plate 202 is pulled out in the lateral direction to allow the pin fins 250 to drop from the top plate 201 to down to the corresponding apertures 252 in the bottom plate 203.

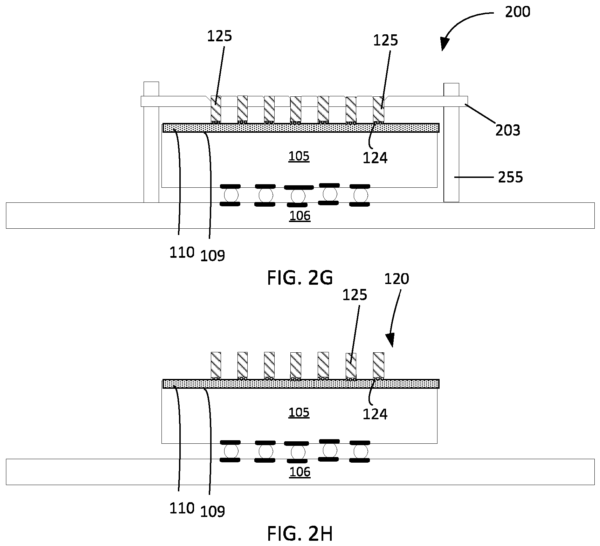

In FIG. 2G, once the pin fins 250 is in place in the bottom plate 203, the top plate 201 along with the middle plate 202 may be disassembled and removed from the pin fin placement assembly 200. The top plate 201 and/or the middle plate 202 removed from the pin fin placement assembly 200 may reduce the thermal mass during the subsequent thermal treatment process . In some examples, the top plate 201 and the middle plate 202 may or may not be removed during the subsequent thermal treatment process.

The thermal treatment process may provide thermal energy to adhere the pin fins 125 onto the solder paste 124 with sufficient and desired adhesion. As illustrated in FIG. 2G, the bottom plate 203 remains in place during the thermal treatment process. In this regard, the bottom plate 203 holds the pin fins 125 in place as the pin fins 125 are secured to the IC die 105 via the solder paste 124. The holding and support from the bottom plate 203 during the thermal treatment process may assist the pin fins 125 to be formed onto the solder paste 124 or on the metallization layer 110with desired integrity and profile without undesired collapse and deterioration.

In FIG. 2H, once the pin fins 125 are securely formed onto the solder paste 125, the pin fin placement assembly 200 may be removed from the PCB 106, forming the thermal dissipating features 120 including the pin fins 125 and the solder paste 124 on the IC die 105.

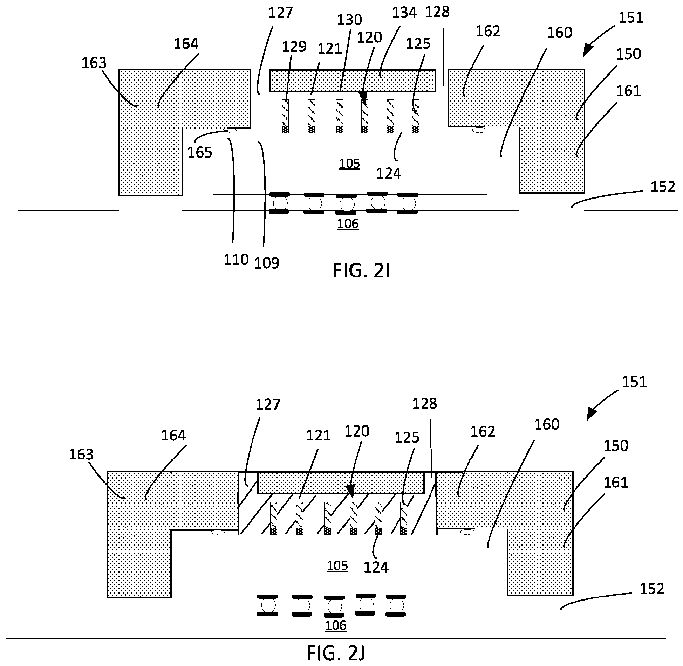

In FIG. 2I, the manifold 150 may be disposed on the PCB 106 through adhesive material 152. The manifold 150 is positioned in a manner that allows the central cavity 160 of the manifold 150 to encase the IC die 105 therein while allowing the plurality of thermal dissipating features 120 to be encased in the plenum 121. The height of the thermal dissipating features 120 may be controlled in a manner so that a top 129 of the thermal dissipating features 120 may be maintained spaced apart from a bottom surface 130 of the center portion 134 of the ceiling 162. It is noted that different configurations of the thermal dissipating features 120 may be utilized to enhance thermal energy circulation and thermal dissipation efficiency. Once the manifold 150 is placed on the PCB 106 with the plurality of thermal dissipating features 120 disposed on the IC die 105, the installation of the temperature control element 151, including the manifold 150 and the thermal dissipating features 120 is then considered completed.

In FIG. 2J, once the manifold 150 is in place, fluid may be supplied to the plenum 121 to facilitate temperature control of the IC die 105 through the plurality of thermal dissipating features 120 disposed on the IC die 105.

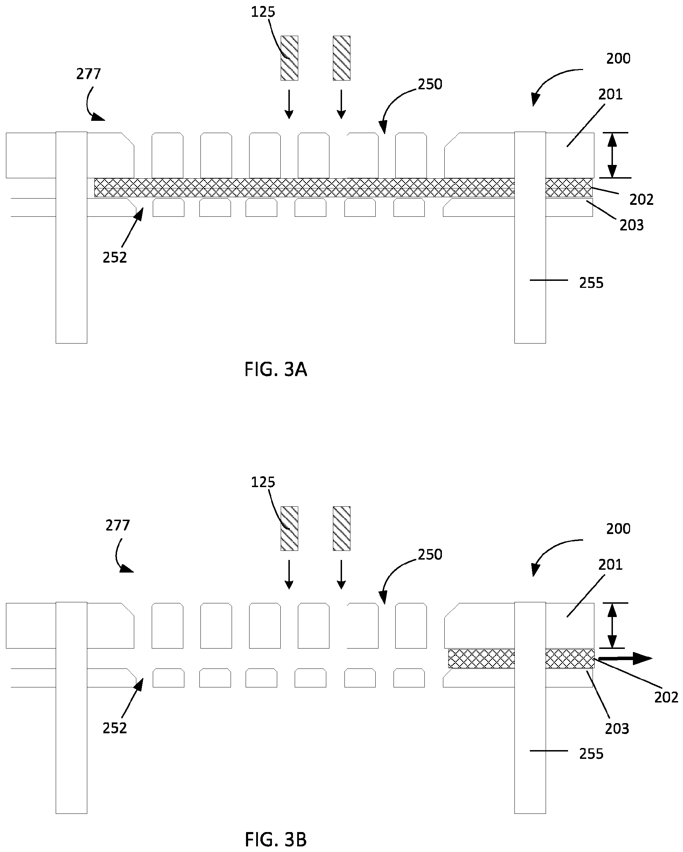

FIG. 3A-3B depict cross-sectional views of an example of the pin fin placement assembly 200 with the middle plate 202 in a non-pulled-out position and in a pulled-out position, respectively. The middle plate 202 is laterally movable relative to the top plate 201 or the bottom plate 203. The middle plate 202 remains in the non-pulled-out position as the pin fins 125 are placed or otherwise driven into the apertures 250 in the top plate 201. The middle plate 202 supports the pin fins 125 within the apertures 250. As described above, the apertures 250 formed in the top plate 201 are vertically aligned with the apertures 252 formed in the bottom plate 203. The top plate 201, middle plate 202, and the bottom plate 203 in combination form a plate body 277. The supporting post 255 is formed below the plate body 277.

After the pin fins 125 are placed in the desired position, such as in the apertures 250 in the top plate 201, the middle plate 202 may be moved laterally position, as shown in FIG. 3B. As a result, the pin fins 125 may drop down into apertures 252 and contact the solder paste 124 formed on the IC die 105 (not shown).

As the numbers, profiles, and distributions of the pin fins 125 formed on the IC die 105 may include different configurations and requirements, a pre-manufactured pattern provided from the pin fin placement assembly 200 may assist in placing the pin fins 125 on the IC die efficiently and precisely. For example, in conventional manners, individual pasting of the pin fins 125 on the IC die often results in inaccurate alignment, time consuming, and positional errors during the process of the placement. By utilizing the pin fin placement assembly 200, the desired patterns, distributions, profiles and configurations of the pin fins 125 may be pre-molded and formed in the top and bottom plates of the pin fin placement assembly 200. Thus, once the pin fins are driven and placed into the apertures formed in the pin fin placement assembly 200, the pin fins are ready to be positioned and soldered onto the IC die with the desired distribution and patterns, thus providing a time-efficient and precise placement of the pin fins on the IC die with minimum errors. Thus, the pin fin placement assembly enables large amounts of pin fins (e.g., tens of thousands or more) to be simultaneously placed on the IC die, instead of being individually placed, soldered and positioned and soldered.

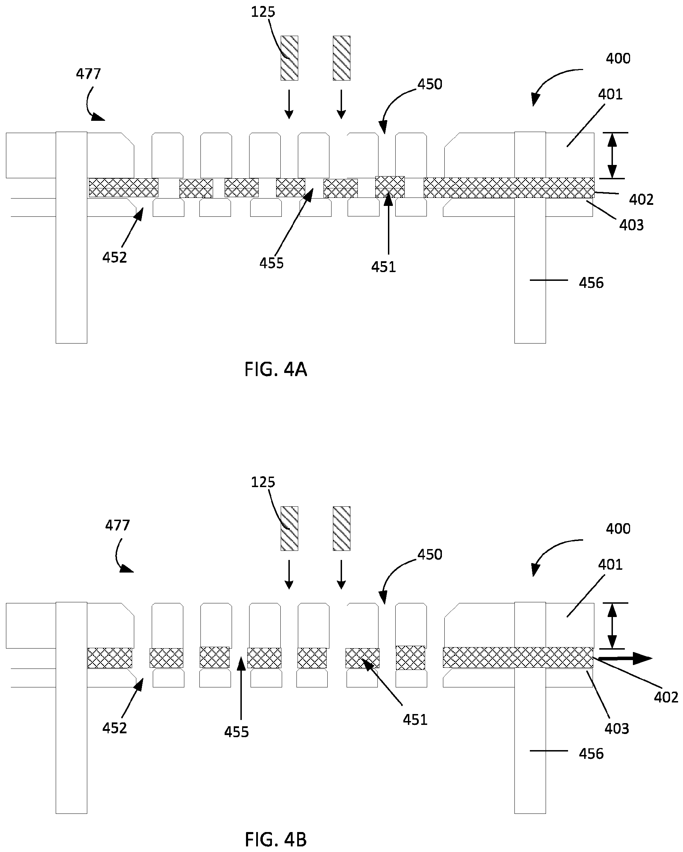

FIGS. 4A-4B depict cross-sectional views of another example of the pin fin placement assembly 400 with the middle plate 402 in a non-pulled-out position and in a pulled-out position, respectively. The middle plate 402 of FIGS. 4A-4B has a plurality of apertures 455 formed therein, providing a structural difference as compared to the middle plate 202 depicted in FIGS. 3A-3B with a solid plate structure. The middle plate 402 has a similar operational mechaniam to allow a laterally movement of the middle plate 402 relative to the top plate 401 or the bottom plate 403. The middle plate 402 remains in the non-pulled-out position as the pin fins 125 are placed or otherwise driven into the apertures 450 in the top plate 401. The middle plate 402 with the portions 451 without the apeartures 455 supports the pin fins 125 within the apertures 450. Once the pin fins 125 are placed in the desired position, such as in the apertures 450 in the top plate 401, the middle plate 402 may be laterally pulled to allow the apertures 455 in the middle plate 402 to be aligned with the apertures 450 in the top plate 401 and the apertures 452 in the bottom plate 403, as depicted in FIG. 4B. Once the apertures 450, 455 and 452 are vertically aligned, the pin fins 125 may be dropped down to the apertures 452 in the bottom plate 403. In this configuration depicted in FIGS. 4A-4B, the middle plate 402 may only be moved laterally in a relatively short distance that may allow alignment of the apeatures 455 in the middle plate 402 with the apertures 450, 452 in the top and bottom plates 401, 403. For example, the middle plate 402 may only need to be laterally moved to allow the portions 451 of the middle plate 402 to be vertically offset from the apertures 450, 452 in the top and bottom plates 401, 403, instead of pulling the middle plate 202 laterally to the very end relative to the top and the bottom plate 201, 203, as depicted in the example of FIG. 3A-3B. By such configuration, a relatively small apparatus footprint and small operational space are obtained.

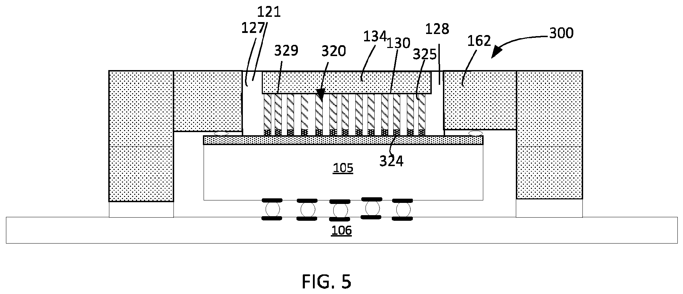

FIG. 5 depicts a cross-sectional view of a different example of temperature control elements 300 utilized to control temperatures of the IC die 105 assembled in the IC package assembly in accordance with aspects of the disclosure. The temperature control element 300 of FIG. 5 is similar to the temperature control element 151 depicted in FIG. 1, except that the thermal dissipating features 320 may be configured differently. For example, the thermal dissipating features 320 may have a top surface 329 in direct contact with the bottom surface 130 of the center portion 134 of the ceiling 162. Thus, the height of the pin fins 325 selected to form the thermal dissipating features 320 is configured differently to accommodate this configuration.

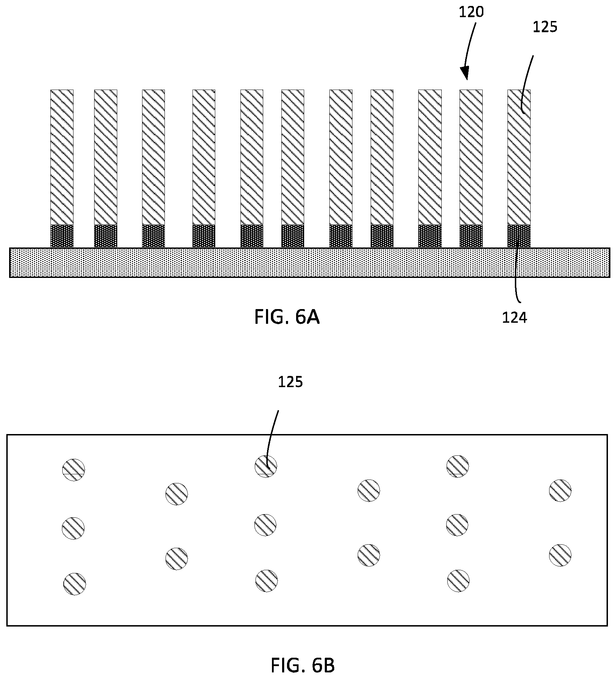

FIG. 6A depicts a cross-sectional view of the plurality of thermal dissipating features 120 and FIG. 6B depicts a top view of the thermal dissipating features 120 of FIG. 6A. As described above, the thermal dissipating feature 120 includes the pin fin 125 disposed on the solder paste 124. The thermal dissipating feature 120 may be configured as arrays or matrix that includes multiple thermal dissipating features 120 equally or non-equally spaced apart from each other. As depicted in the top view of the thermal dissipating feature 120 in FIG. 6B, the thermal dissipating feature 120 may be configured in a circular configuration to facilitate thermal dissipation. In one example, the thermal dissipating feature 120 may have a diameter between about 20 µm and about 80 µm.

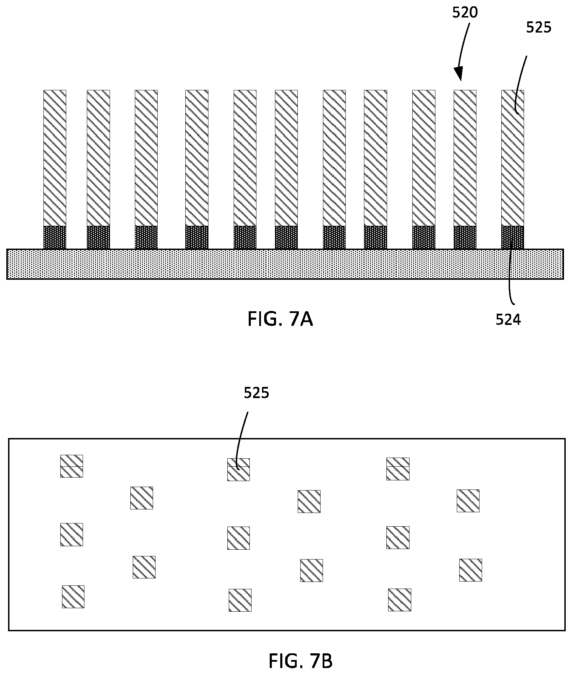

In another example, depicted in FIGS. 7A-7B, the thermal dissipating feature 520 includes the pin fin 525 disposed on the solder bump 524, as shown in the cross-sectional view of FIG. 7A. The thermal dissipating feature 520 may be configured as arrays or matrix that includes multiple thermal dissipating features 520 equally or non-equally spaced apart from each other. The thermal dissipating feature 520 may be configured to have a rectangular configuration, as shown in the top view in FIG. 7B. It is noted that the thermal dissipating feature 520 may be a longitudinal structure. For example, the thermal dissipating feature 520 may have a dimension between about 20 µm and about 80 µm.

It is noted that based on different configurations, densities, distributions, and profiles of the pin fins 125, 525, the apertures 250, 252 formed in the top plate 201 and the bottom plate 203 may be changed or altered accordingly to accommodate different configurations, densities, distributions, and profiles of the pin fins 125, 525.

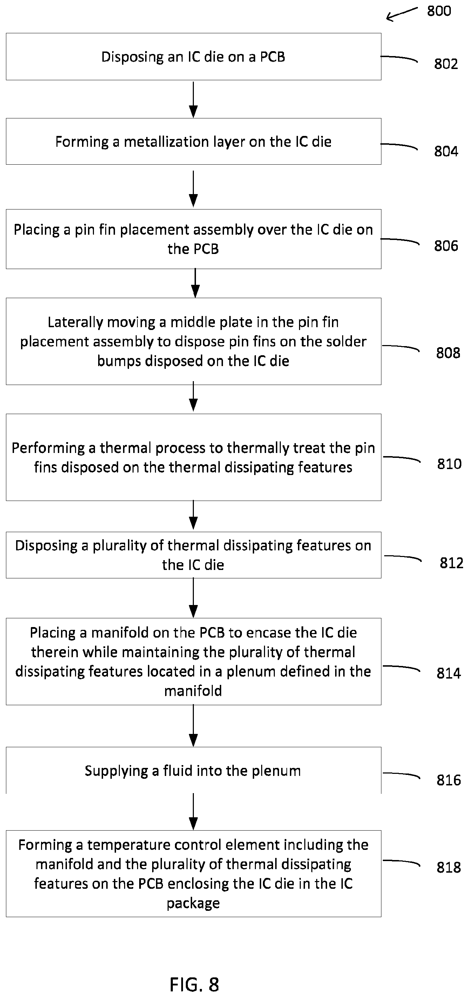

FIG. 8 depicts a flow diagram for manufacturing an IC package including an IC die having a temperature control element utilized to control the temperature of the IC die in accordance with aspects of the disclosure. Such method may be performed using suitable manufacturing processes, including depositing, etching, lithography, polishing, soldering, or any suitable techniques. It should be understood that the operations involved in the following methods need not be performed in the precise order described. Rather, various operations may be handled in a different order or simultaneously, and operations may be added or omitted.

Referring to FIG. 8, in block 802, an IC die, such as the IC die 105 described above, may be disposed on a PCB, such as the PCB 106 described above. The IC die 105 may include device structures, transistors, or other electronic components formed on a device region of the IC die 105.

In block 804, a metallization layer, such as the metallization layer 110, may be formed on the IC die. The metallization layer may be formed on a surface opposite of the surface where the device structures, transistors, or other electronic components are formed in the device region of the IC die.

In block 806, a pin fin placement assembly 200 is placed over the IC die 105 on the PCB 106.

In block 808, the middle plate 202 of the pin fin placement assembly 200 is laterally pulled out to allow the pin fins 125 to be dropped onto the solder paste 124 disposed on the IC die 105.

In block 810, a thermal process is performed on the pin fins 125 to allow the pin fins 125 to securely adhered and soldered onto the solder paste 124 or metallization layer 110 formed on the IC die 105.

In block 812, once the pin fins 125 are securely adhered and soldered onto the solder paste 124, the pin fin placement assembly 200 may be removed from the PCB 106. Thus, a plurality of thermal dissipating features 120 may be disposed on the IC die 105.

In block 814, a manifold 150 is placed on the PCB 106 to encase the IC die 105 therein while maintaining the plurality of thermal dissipating features 120 located in a plenum 121 defined in the manifold 150.

In block 816, a fluid may be supplied into the plenum 121 of the manifold 150 to efficiently control the temperature of the IC die 105 through the plurality of thermal dissipating features 120.

In block 818, a temperature control element including the manifold 150 and the plurality of thermal dissipating features 120 is then implemented on the PCB 106 encasing the IC die 105 to form an IC package assembly with efficiency temperature dissipation control.

According to another aspect, a pin fin placement assembly utilized to form pin fins in a thermal dissipating feature is provided. The pin fin placement assembly may place the pin fins on an IC die disposed in the IC package. The pin fin placement assembly may assist massively placing the pin fins with desired profiles and numbers on desired locations of the IC die. The plurality of pin fins is formed in a first plurality of apertures in the pin fin placement assembly. A thermal process is then performed to solder the plurality of pin fins on the IC die.

The features described herein allow a temperature control element being formed as an integral part of an IC package assembly that may have high heat dissipation efficiency to an IC die during operation assembled in the package assembly. The temperature control element may assist in temperature control of the IC die when in operation. In one example, the temperature control element may have a plurality of thermal dissipating features disposed on a first surface of the IC die encased under a manifold to efficiently control and dissipate the thermal energy from the IC die when in operation. A second surface opposite to the first surface of the IC die may include a plurality of devices, such as semiconductors transistors, devices, electrical components, circuits, or the like, that may generate thermal energy when in operation. The thermal dissipating features may be manufactured by utilizing the pin fin placement assembly to efficiently and precisely the pin fins on desired locations of the IC die. Different configurations of the thermal dissipating features may be utilized to accommodate different device layouts with different thermal energy generation across the substrate in the IC die. Thus, the temperature control element may provide an IC die with high efficiency of heat dissipation that is suitable for 3D IC package structures and requirements.

## Claims

1. A method for manufacturing a temperature control element (151, 300) in an IC package (100), comprising:
placing a pin fin placement assembly (200) on a PCB (106), the PCB (106) including an IC die (105) positioned thereon;
providing a plurality of pin fins (125, 325, 525) in a first plurality of apertures (250) in the pin fin placement assembly (200); and
performing a thermal process to solder the plurality of pin fins (125, 325, 525) on the IC die (105),
wherein the plurality of pin fins (125, 325, 525) is configured to control and dissipate thermal energy from the IC die (105) when in operation.

2. The method of claim 1, further comprising:
removing the pin fin placement assembly (200) from the PCB (106).

3. The method of claim 1 or 2, wherein providing the plurality of pin fins (125, 325, 525) further comprises:
providing the plurality of pin fins (125, 325, 525) in the first plurality of apertures (250) formed in a top plate (201, 401) of the pin fin placement assembly (200).

4. The method of claim 3, further comprising:
driving the plurality of pin fins (125, 325, 525) in the first plurality of apertures (250) in the top plate (201, 401) by vibration or brushing.

5. The method of claim 3 or 4, further comprising:
pulling a middle plate (202, 402) in the pin fin placement assembly (200) in a lateral direction, such that the plurality of pin fins (125, 325, 525) from the first plurality of apertures (250) in the top plate drop into a second plurality of apertures (252) formed in a bottom plate (203, 403) of the pin fin placement assembly (200) disposed below the middle plate (202, 402).

6. The method of claim 4 or 5, wherein the first plurality of apertures (250) formed in the top plate (201, 401) is vertically aligned with the second plurality of apertures (252) formed in the bottom plate (203, 403).

7. The method of any one of claims 1 to 6, further comprising:
maintaining the plurality of pin fins (125, 325, 525) in a second plurality of apertures (252) formed in a bottom plate (203, 403) in the pin fin placement assembly (200) while performing the thermal process.

8. The method of any one of claims 1 to 7, wherein soldering the pin fins (125, 325, 525) further comprises:
soldering the pin fins (125, 325, 525) onto corresponding solder paste (124) formed on the IC die (105), and/or
wherein placing the pin fin placement assembly (200) further comprises:
placing the pin fin placement assembly (200) in an alignment hole formed in the PCB (106).

9. The method of any one of claims 1 to 8, wherein the pin fin placement assembly (200) allows the plurality of pin fins (125, 325, 525) to be placed on the IC die (105) simultaneously.

10. The method of any one of claims 1 to 9, further comprising:
placing a manifold (150) on the PCB (106) to encase the IC die (105) therein while maintaining the plurality of pin fins (125, 325, 525) located in a plenum (121) defined in the manifold (150), and optionally further comprising:
supplying a fluid into the plenum (121) to regulate a thermal energy transmitted from the IC die (105).

11. The method of any one of claims 1 to 10, wherein the pin fins (125, 325, 525) are manufactured from a material selected from copper, aluminum, tungsten, gold, silver, combinations thereof or alloys thereof, and/or
wherein the plurality of pin fins (125, 325, 525) have a circular configuration, a rectangular configuration, a longitudinal structure, or some combination thereof, and/or
wherein the plurality of pin fins (125, 325, 525) are arranged in one or more arrays or matrices.

12. A pin fin placement assembly (200), comprising:
a top plate (201, 401), a middle plate (202, 402), and a bottom plate (203, 403) vertically assembled to form a plate body (277), wherein the middle plate (202, 402) is laterally movable relative to the top plate (201, 401) or the bottom plate (203, 403);
a supporting post (255) disposed below the plate body (277);
a first plurality of apertures (250) formed in the top plate (201, 401); and
a second plurality of apertures (252) formed in the bottom plate (203, 403), wherein the first and the second plurality of apertures (250, 252) are vertically aligned, wherein the first and the second apertures (250, 252) are configured to receive pin fins (125, 325, 525) to be disposed on an IC die (105).

13. The pin fin placement assembly (200) of claim 12, wherein the top plate (201, 401) is removable from the plate body (277), and/or
wherein the first plurality of apertures (250) are configured to receive a corresponding pin fin (125, 325, 525) to be disposed therein.

14. The pin fin placement assembly (200) of claim 12 or 13, wherein the corresponding pin fin (125, 325, 525) disposed in the first plurality of apertures (250) is configured to be dropped down to the second plurality of the apearutres (252) when the middle plate (202, 402) is lateral moved to a pull-out position.

15. The pin fin placement assembly (200) of any one of claims 12 to 14, wherein the supporting post (255) is configured to be placed in an alignment hole formed in a PCB (106).

## Patentansprüche

1. Verfahren zum Herstellen eines Temperaturregelungselements (151, 300) in einem IC-Gehäuse (100), umfassend:
Platzieren einer Stiftrippenpositionierungsanordnung (200) auf einer Leiterplatte (106), wobei die Leiterplatte (106) einen darauf positionierten IC-Chip (105) umfasst;
Bereitstellen einer Mehrzahl von Stiftrippen (125, 325, 525) in einer ersten Mehrzahl von Öffnungen (250) in der Stiftrippenpositionierungsanordnung (200); und
Durchführen eines thermischen Prozesses, um die Mehrzahl von Stiftrippen (125, 325, 525) auf den IC-Chip (105) zu löten,
wobei die Mehrzahl von Stiftrippen (125, 325, 525) dazu konfiguriert ist, im Betrieb Wärmeenergie von dem IC-Chip (105) zu regeln und abzuführen.

2. Verfahren nach Anspruch 1, ferner umfassend:
Entfernen der Stiftrippenpositionierungsanordnung (200) von der Leiterplatte (106).

3. Verfahren nach Anspruch 1 oder 2, wobei Bereitstellen der Mehrzahl von Stiftrippen (125, 325, 525) ferner Folgendes umfasst:
Bereitstellen der Mehrzahl von Stiftrippen (125, 325, 525) in der ersten Mehrzahl von Öffnungen (250), die in einer oberen Platte (201, 401) der Stiftrippenpositionierungsanordnung (200) ausgebildet ist.

4. Verfahren nach Anspruch 3, ferner umfassend:
Eintreiben der Mehrzahl von Stiftrippen (125, 325, 525) in die erste Mehrzahl von Öffnungen (250) in der oberen Platte (201, 401) durch Vibration oder Bürsten.

5. Verfahren nach Anspruch 3 oder 4, ferner umfassend:
Ziehen einer mittleren Platte (202, 402) in der Stiftrippenpositionierungsanordnung (200) in einer seitlichen Richtung derart, dass die Mehrzahl von Stiftrippen (125, 325, 525) aus der ersten Mehrzahl von Öffnungen (250) in der oberen Platte in eine zweite Mehrzahl von Öffnungen (252) fällt, die in einer unteren Platte (203, 403) der Stiftrippenpositionierungsanordnung (200) ausgebildet ist, wobei die untere Platte unterhalb der mittleren Platte (202, 402) angeordnet ist.

6. Verfahren nach Anspruch 4 oder 5, wobei die erste Mehrzahl von Öffnungen (250), die in der oberen Platte (201, 401) ausgebildet ist, vertikal mit der zweiten Mehrzahl von Öffnungen (252) ausgerichtet ist, die in der unteren Platte (203, 403) ausgebildet ist.

7. Verfahren nach einem der Ansprüche 1 bis 6, ferner umfassend:
Halten der Mehrzahl von Stiftrippen (125, 325, 525) in einer zweiten Mehrzahl von Öffnungen (252), die in einer unteren Platte (203, 403) in der Stiftrippenpositionierungsanordnung (200) ausgebildet ist, während des Durchführens des thermischen Prozesses.

8. Verfahren nach einem der Ansprüche 1 bis 7, wobei Löten der Stiftrippen (125, 325, 525) ferner Folgendes umfasst:
Löten der Stiftrippen (125, 325, 525) auf entsprechende Lötpaste (124), die auf dem IC-Chip (105) ausgebildet ist, und/oder
wobei Platzieren der Stiftrippenpositionierungsanordnung (200) ferner Folgendes umfasst:
Platzieren der Stiftrippenpositionierungsanordnung (200) in einem Ausrichtungsloch, das in der Leiterplatte (106) ausgebildet ist.

9. Verfahren nach einem der Ansprüche 1 bis 8, wobei die Stiftrippenpositionierungsanordnung (200) es ermöglicht, dass die Mehrzahl von Stiftrippen (125, 325, 525) gleichzeitig auf dem IC-Chip (105) platziert wird.

10. Verfahren nach einem der Ansprüche 1 bis 9, ferner umfassend:
Platzieren eines Verteilers (150) auf der Leiterplatte (106), um den IC-Chip (105) darin einzuschließen, während die Mehrzahl von Stiftrippen (125, 325, 525), die in einem in dem Verteiler (150) definierten Plenum (121) angeordnet sind, gehalten wird, das in dem Verteiler (150) definiert ist, und optional ferner umfassend:
Zuführen eines Fluids in das Plenum (121), um eine von dem IC-Chip (105) übertragene Wärmeenergie zu regulieren.

11. Verfahren nach einem der Ansprüche 1 bis 10, wobei die Stiftrippen (125, 325, 525) aus einem Material hergestellt sind, das aus Kupfer, Aluminium, Wolfram, Gold, Silber, Kombinationen davon oder Legierungen davon ausgewählt ist, und/oder
wobei die Mehrzahl von Stiftrippen (125, 325, 525) eine kreisförmige Konfiguration, eine rechteckige Konfiguration, eine längliche Struktur oder eine Kombination davon aufweist, und/oder
wobei die Mehrzahl von Stiftrippen (125, 325, 525) in einem oder mehreren Arrays oder Matrizen angeordnet ist.

12. Stiftrippenpositionierungsanordnung (200), umfassend:
eine obere Platte (201, 401), eine mittlere Platte (202, 402) und eine untere Platte (203, 403), die vertikal zu einem Plattenkörper (277) zusammengefügt sind, wobei die mittlere Platte (202, 402) relativ zu der oberen Platte (201, 401) oder der unteren Platte (203, 403) seitlich beweglich ist;
einen Stützpfosten (255), der unterhalb des Plattenkörpers (277) angeordnet ist;
eine erste Mehrzahl von Öffnungen (250), die in der oberen Platte (201, 401) ausgebildet ist; und
eine zweite Mehrzahl von Öffnungen (252), die in der unteren Platte (203, 403) ausgebildet ist, wobei die erste und die zweite Mehrzahl von Öffnungen (250, 252) vertikal ausgerichtet sind, wobei die erste und die zweite Öffnung (250, 252) dazu konfiguriert sind, Stiftrippen (125, 325, 525) aufzunehmen, die auf einem IC-Chip (105) anzuordnen sind.

13. Stiftrippenpositionierungsanordnung (200) nach Anspruch 12, wobei die obere Platte (201, 401) von dem Plattenkörper (277) abnehmbar ist, und/oder
wobei die erste Mehrzahl von Öffnungen (250) dazu konfiguriert ist, eine entsprechende Stiftrippe (125, 325, 525) aufzunehmen, die darin anzuordnen ist.

14. Stiftrippenpositionierungsanordnung (200) nach Anspruch 12 oder 13, wobei die entsprechende Stiftrippe (125, 325, 525), die in der ersten Mehrzahl von Öffnungen (250) angeordnet ist, dazu konfiguriert ist, in die zweite Mehrzahl der Öffnungen (252) herabzufallen, wenn die mittlere Platte (202, 402) seitlich in eine Ausziehposition bewegt wird.

15. Stiftrippenpositionierungsanordnung (200) nach einem der Ansprüche 12 bis 14, wobei der Stützpfosten (255) dazu konfiguriert ist, in einem Ausrichtungsloch platziert zu werden, das in einer Leiterplatte (106) ausgebildet ist.

## Revendications

1. Procédé de fabrication d'un élément de régulation de température (151, 300) dans un boîtier IC (100), comprenant :
le placement d'un ensemble de placement d'ailette de broche (200) sur un PCB (106), le PCB (106) comportant une puce IC (105) disposée sur celui-ci ;
la fourniture d'une pluralité d'ailettes de broche (125, 325, 525) dans une première pluralité d'ouvertures (250) dans l'ensemble de placement d'ailette de broche (200) ; et
la réalisation d'un traitement thermique pour braser la pluralité d'ailettes de broche (125, 325, 525) sur la puce IC (105),
dans lequel la pluralité d'ailettes de broche (125, 325, 525) est configurée pour réguler et dissiper l'énergie thermique de la puce IC (105) en fonctionnement.

2. Procédé selon la revendication 1, comprenant en outre :
le retrait de l'ensemble de placement d'ailette de broche (200) du PCB (106).

3. Procédé selon la revendication 1 ou 2, dans lequel la fourniture de la pluralité d'ailettes de broche (125, 325, 525) comprend en outre :
la fourniture de la pluralité d'ailettes de broche (125, 325, 525) dans la première pluralité d'ouvertures (250) formées dans une plaque supérieure (201, 401) de l'ensemble de placement d'ailette de broche (200).

4. Procédé selon la revendication 3, comprenant en outre :
l'entraînement de la pluralité d'ailettes de broche (125, 325, 525) dans la première pluralité d'ouvertures (250) dans la plaque supérieure (201, 401) par vibration ou brossage.

5. Procédé selon la revendication 3 ou 4, comprenant en outre :
le tirage d'une plaque intermédiaire (202, 402) dans l'ensemble de placement d'ailette de broche (200) dans une direction latérale, de sorte que la pluralité d'ailettes de broche (125, 325, 525) de la première pluralité d'ouvertures (250) dans la plaque supérieure tombent dans une seconde pluralité d'ouvertures (252) formées dans une plaque inférieure (203, 403) de l'ensemble de placement d'ailette de broche (200) disposée sous la plaque intermédiaire (202, 402).

6. Procédé selon la revendication 4 ou 5, dans lequel la première pluralité d'ouvertures (250) formée dans la plaque supérieure (201, 401) est alignée verticalement avec la seconde pluralité d'ouvertures (252) formée dans la plaque inférieure (203, 403).

7. Procédé selon l'une quelconque des revendications 1 à 6, comprenant en outre :
le maintien de la pluralité d'ailettes de broche (125, 325, 525) dans une seconde pluralité d'ouvertures (252) formées dans une plaque inférieure (203, 403) dans l'ensemble de placement d'ailette de broche (200) tout en effectuant le traitement thermique.

8. Procédé selon l'une quelconque des revendications 1 à 7, dans lequel le brasage des ailettes de broche (125, 325, 525) comprend en outre :
le brasage des ailettes de broche (125, 325, 525) sur une pâte à braser correspondante (124) formée sur la puce IC (105), et/ou
dans lequel le placement de l'ensemble de placement d'ailette de broche (200) comprend en outre :
le placement de l'ensemble de placement d'ailette de broche (200) dans un trou d'alignement formé dans le PCB (106).

9. Procédé selon l'une quelconque des revendications 1 à 8, dans lequel l'ensemble de placement d'ailette de broche (200) permet de placer simultanément la pluralité d'ailettes de broche (125, 325, 525) sur la puce IC (105).

10. Procédé selon l'une quelconque des revendications 1 à 9, comprenant en outre :
le placement d'un collecteur (150) sur le PCB (106) pour y enfermer la puce IC (105) tout en maintenant la pluralité d'ailettes de broche (125, 325, 525) situées dans un plénum (121) défini dans le collecteur (150), et comprenant en outre en option :
la fourniture d'un fluide dans le plénum (121) afin de réguler l'énergie thermique transmise par la puce IC (105).

11. Procédé selon l'une quelconque des revendications 1 à 10, dans lequel les ailettes de broche (125, 325, 525) sont fabriquées à partir d'un matériau choisi parmi le cuivre, l'aluminium, le tungstène, l'or, l'argent, des combinaisons de ceux-ci ou des alliages de ceux-ci, et/ou
dans lequel la pluralité d'ailettes de broche (125, 325, 525) présentent une configuration circulaire, une configuration rectangulaire, une structure longitudinale ou une combinaison de celles-ci, et/ou
dans lequel la pluralité d'ailettes de broche (125, 325, 525) sont disposées dans un ou plusieurs réseaux ou matrices.

12. Ensemble de placement d'ailette de broche (200), comprenant :
une plaque supérieure (201, 401), une plaque intermédiaire (202, 402) et une plaque inférieure (203, 403) assemblées verticalement pour former un corps de plaque (277), dans lequel la plaque intermédiaire (202, 402) est mobile latéralement par rapport à la plaque supérieure (201, 401) ou à la plaque inférieure (203, 403) ;
une colonnette de support (255) disposée sous le corps de plaque (277) ;
une première pluralité d'ouvertures (250) formées dans la plaque supérieure (201, 401) ; et
une seconde pluralité d'ouvertures (252) formées dans la plaque inférieure (203, 403), dans lequel la première et la seconde pluralités d'ouvertures (250, 252) sont alignées verticalement, dans lequel les première et seconde ouvertures (250, 252) sont configurées pour recevoir des ailettes de broche (125, 325, 525) à disposer sur une puce IC (105).

13. Ensemble de placement d'ailette de broche (200) selon la revendication 12, dans lequel la plaque supérieure (201, 401) est amovible du corps de plaque (277), et/ou
dans lequel la première pluralité d'ouvertures (250) est configurée pour recevoir une ailette de broche correspondante (125, 325, 525) destinée à y être disposée.

14. Ensemble de placement d'ailette de broche (200) selon la revendication 12 ou 13, dans lequel l'ailette de broche correspondante (125, 325, 525) disposée dans la première pluralité d'ouvertures (250) est configurée pour tomber dans la seconde pluralité d'ouvertures (252) lorsque la plaque intermédiaire (202, 402) est déplacée latéralement vers une position de retrait.

15. Ensemble de placement d'ailette de broche (200) selon l'une quelconque des revendications 12 à 14, dans lequel la colonnette de support (255) est configurée pour être placée dans un trou d'alignement formé dans un PCB (106).
